# EUROPEAN PATENT APPLICATION

(11) **EP 3 521 000 A1**
(43) Date of publication of application: **07.08.2019**
(21) Application number: 17862957.2
(22) Date of filing: 27.09.2017
(51) Int. Cl.: B29C 65/34

(54) **METHOD FOR JOINING SUBSTRATES AND PLASTICS USING AN AREA OF CONTROLLED HEAT ADHESION**

(30) Priority: 28.09.2016 ES 201600809
(71) Applicant: Universidad De Sevilla, 41013 Sevilla (ES)
(72) Inventor: QUERO REBOUL, José Manuel, 41092 Sevilla (ES); DOMÍNGUEZ BLAS, Salvador, 41092 Sevilla (ES); PERDIGONES SÁNCHEZ, Francisco Antonio, 41092 Sevilla (ES); FRANCO GONZÁLEZ, Emilio, 41092 Sevilla (ES); CABELLO VALVERDE, Miguel, 41092 Sevilla (ES)
(74) Representative: Pons
(86) International application number: PCT/ES2017/000119
(87) International publication number: WO 2018/073465

(57) **Abstract**

The subject matter of the invention is a method for the adhesion of substrates to plastics that may or may not be machined. This is a manufacturing process for a plastic (1), that may be machined or not, to a substrate (2) with a metal on its surface. The process is based on the generation of heat, caused by the Joule effect, when an electric current passes through an element that conducts electricity (3). A relevant aspect of the invention is the inclusion of a mechanical-thermal barrier (8), the main function of which is to lower the temperature so that the plastic material solidifies exactly in the area where said barrier is present. The invention lies in the area of manufacturing and materials technology, and can be applied in a very broad range of activities: the main uses for this adhesion and shaping of structures lies in the manufacture of lab-on-chip circuits for biological or environmental applications. It can also be used to make protective plastic casings over electronic circuits assembled on printed circuits.

## Description

### Object of the Invention

The subject matter of the invention is a method for the adhesion of substrates to plastics that may or may not be machined. This is a manufacturing process for a plastic (1), that may be machined or not, to a substrate (2) with a metal on its surface. The process is based on the generation of heat, caused by the Joule effect, when an electric current passes through an element that conducts electricity (3). A relevant aspect of the invention is the inclusion of a mechanical-thermal barrier (6), the main function of which is to lower the temperature so that the plastic material solidifies exactly in the area where said barrier is present.

The invention lies in the area of manufacturing and materials technology, and can be applied in a very broad range of activities: the main uses for this adhesion and shaping of structures lies in the manufacture of lab-on-chip circuits for biological or environmental applications. It can also be used to make protective plastic casings over electronic circuits assembled on printed circuits.

### State of the Art

The most common methods of adhesion currently used between polymer structures (plastics) and substrates involve direct bonding with double-faced adhesive tape as well as the application of a bonding agent, whether it be by means of curing by temperature or by means of ultraviolet radiation. Both techniques have the drawback of having the presence of bonding agents in some areas wherein they are not desired, such as in the case of the channels present in microfluidic circuits, for example, wherein the behaviour of the liquids can vary when crossing through the channel, or they can be contaminated by being in contact with the adhesive tape.

The first of these bonding techniques consists of the placement of adhesive tape between the substrate and the polymer to be bonded. These can be machined in order to bond the thermoplastic only in the desired areas, preventing the previously mentioned problem, which would give us a bonding process that is cleaner and has less of an effect on the liquids. The problem of this improvement comes from the fact that the most common processes for performing this machining of the tape is by means of lasers or milling, for which reason the bonding method ceases to be applicable in a process for assembly line production.

This tape can have different adhesives, such as for example the ones presented in US 4,218,279, US 4,769,399, US 5,457,149 or they can even be conductors in order to able to use them as an additional conduction layer within the electronic circuit, like the one shown in US 3,475,213. This tape has been useful for manufacturing many useful devices until now, like the ones shown in [7-8].

The second of the two techniques currently used consists of the deposition of a very thin layer of bonding agent between the PCB substrate (Printed circuit board) and the polymer. The curing can be performed by different methods, such as the ones shown in US 4,717,805 A, or in US 4426243 A, which correspond to techniques for curing by means of radiation (such as ultraviolet rays) and by means of the application of temperature (room temperature in this case), respectively. These bonding methods have been used to manufacture Lab-on-Chip in functional PCB substrates, like the ones shown in [9-10]. Techniques can also be used such as bonding by stamping [11], which is no more than the controlled deposition of bonding agent onto the surface to be adhered by placing it on a medium soaked in the adhesive.

The use of bonding agents introduces problems when making channels in the case of said channel having a small size, given that it tends to enter into them even sometimes closing them off. This fact is worsened when the alignment between the machined polymer and the substrate must be performed, since the movement of one portion over the other produces a displacement of the bonding agent, for which reason it encourages the agglomeration thereof in portions of the polymer structure, in which case methods of alignment by guides would be necessary. Furthermore, once it is cured, the same problem appears which occurred in bonding by means of adhesive tape, that the bonding agent existing in the channels contaminates and has an effect on the liquids that circulate through them. Unless it is a special bonding agent for the application used, for example, in biological applications it would be obligatory for the bonding agent to have biocompatible properties. In this case, furthermore, there is no possibility of preventing this problem by means of machining.

Although the two cited bonding methods are the most common, there are others, such as the SU-8 and PCB bonding, which is produced by curing the polymer on the substrate [12] and using PMMA (poly(methyl metacrylate)) as a means of bonding for other polymers [13].

Also, if the substrates whereto the polymers are adhered are also polymeric materials, the application of heat to fuse the contact area between contact areas is commonly used to thereby fuse it. The heat can be produced by friction, magnetic induction or direct heating [14].

The problem of these types of techniques is that in the process all the contact area is heated equally, for which reason it cannot be used to bond substrates with microfluidic structures on the surface thereof since they are completely deformed or destroyed.

Regarding the use given until now to the losses produced in a resistor due to the Joule effect, it has, for example, the use thereof for the manufacture of gas sensors, micropumps, pressure sensors, flow sensors, microvalves and temperature sensors, among others [15-19]. It has also been used previously to fuse a silicon substrate with another made of silica crystal [20], or to fuse two polymers to each other [21], but no research paper has been found wherein it was used to bond a polymer with an RGB substrate.

### References

*1.* US 4,218,279 A*, Bonding method employing film adhesives containing an epoxide resin, August 1980; Original assignor: Ciba-Geigy Corporation; Inventors: George E. Green.*
*2.* US 4,769,399*, Epoxy adhesive film for electronic applications, September 1988; Original assignor: Minnesota Mining and Manufacturing Company; Inventors: James L. Schenz*
*3.* US 5,457,149*, Reworkable adhesive for electronic applications, October 1995; Original assignor: Minnesota Mining and Manufacturing Company, Inventors: Joyce B. Hall, Peter B. Hogerton, Jean-Marc Pujol.*
*4.* US 3,475,213*, Electrically conductive adhesive tape, September 1965; Original assignor: Minnesota Mining and Manufacturing Company; Inventors: Robert H. Stow.*
5. US 4,717,605 A*, Radiation curable adhesives, January 1988; Original assignor: Merck Patern Gesellschaft mit Beschrankter Haftung: Inventors: Manfred Urban, Jörg Ohngemach.*
*6.* US 4426243 A*, Room-temperature-curable, quick-setting acrylic*/*epoxy adhesives and methods of bonding, December 1981; Original assignor: Illinois Tool Works Inc; Inventors: Paul C. Brigss*
*7.* A. Petropoulos, G, Kaltsas, D. Goustouridis, E. Gogolides, "A flexible capacitive device for pressure and tactile sensing", Procedia Chemistry, 1(1), 867-870, 2009
8. D. Moschou. T Trantidou, A Regoutz, D. Carta, H. Morgan, T. Prodromakis, "Surface and electrical characterization of Ag/AgCl pseudo-reference electrodes manufactured with commercially available PCB technologies", Sensors, 15(8), 18102-18113, 2015*.*
*9.* S. Schlautmann, G. A. J. Besselink, Radhakrishna Prabdu G, R. M. B. Schasfoort, "Fabrication of a microfluidic chip by UV bonding at room temperature for integration of temperature-sensitive layers". Journal of Micromechanics and Microengineering, 13, 81-84, 2003*.*
*10.* I. Burdallo, C. Jimenez-Jorquera, C. Fernández-Sánchez, A. Baldi, "Integration of microelectronic chips in microfluidic systems on printed circuit board", Journal of Micromechanics and Microengineering, 22(10), 105022, 2012*.*
*11*. S. Gassmann, A Trozjuk, J. Singhal, H. Schuette, M L. Miranda., O. Zielinski, "PCB based micro fluidic system for thermal cycling of seawater samples. In Industrial Technology (ICIT)" 2015 IEEE International Conference on (p. 3365-3369), IEEE, 2015*.*
*12.* C. Aracil, F Perdigones, J.M. Moreno, A. Luque, J.M. Quero, "Portable Lab-on-PCB platform for autonomous micromixing", Microelectronic Engineering, 131, 13-18, 2015*.*
*13.* K Kontakis, A. Petropoulos, G Kaltsas, T. Speliotis, E. Gogolides, "A novel microfluidic integration technology for PCB-based devices: Application to microflow sensing" Microelectronic Engineering, 86(4), 1382-1384, 2009*.*
*14.* A. Yousefpour, M. Hojjati, J.P. Immarigeon, "Fusion Bonding/Welding of Thermoplastic Composites", Journal of Thermoplastic Composite Materials 17(4), 303-341, 2004*.*
*15.* J. Laconte, C. Dupont, D. Flandre, J.P Raskin, "SOI CMOS Compatible Low-Power Microheater Optimization for the Fabrication of Smart Gas Sensors", IEEE Sensors Journal vol. 4 (5), 670-680, 2004
*16.* K.L. Zhang, S.K. Chou, and S.S. Ang, "Fabrication, modeling and testing of a thin film Au/Ti microheater", International Journal of Thermal Sciences, vol. 46 (6), p. 580-588, 2006*.*
*17.* M.A. Gajda, and H. Ahmed, "Application of thermal silicon sensors on membranes", Sensor and Actuators A vol. 49(1-2), p. 1-9, 1995*.*
*18.* J. Puigcorbe, D. Vogel, B. Michel, A Vila, I. Gracia, C. Cane, and J. R. Morante, "Thermal and mechanical analysis of micromachined gas sensors", Journal of Micromechanics and Microengineering vol. 13 (5), p. 548-556, 2003*.*
*19.* R. Phatthanakun, P. Deelda, W. Pummara, C. Sriphung, C. Pantong, N. Chomnawang, "Design and Fabrication of Thin-Film Aluminum Microheater and Nickel Temperature Sensor", Nano/Micro Engineered and Molecular Systems (NEMS), 2012 7th IEEE international Conference on. IEEE, 2012*.*
*20.* T.Y Cheng, L. Lin,K. Najafi, "Localized silicon fusion and eutectic bonding for MEMS fabrication and packaging", Microelectromechanicai Systems, Journal of, 9(1), 3-8, 2000*.*
*21.* C.W. Tsao, D.L. DeVoe, "Bonding of thermoplastic polymer microfluidics" Microfluidics and Nanofluidics, 6(1), 1-16, 2009

### Description of the Figures

Figure 1: Figure summarising the invention. (a) Plan view of the plastic placed on the substrate (b) final result of the bonding.
   (1) Plastic
   (2) Substrate
   (3) Metal resistor
   (4) and (5) Electrical connections (6) Mechanical-thermal barrier
Figure 2: Generic curve of heating and cooling steps
Figure 3: Bonding process of the plastic, (a) Placement and pressure, (b) adhesion and (c) end of bonding.
   (7) Pressure element

### Description of the invention

The invention is a manufacturing process for adhering plastics, that may be machined or not, to a surface with a metal on a substrate, such that the adhesion area is controlled. The process is based on the generation of heat produced by the Joule effect, when an electric current passes through an element that conducts electricity. An important characteristic of the invention is the inclusion of a mechanical-thermal barrier, the main function of which is to stop the temperature from increasing and lower it so that the plastic is solidified in that point, thereby delimiting the adhesion area.

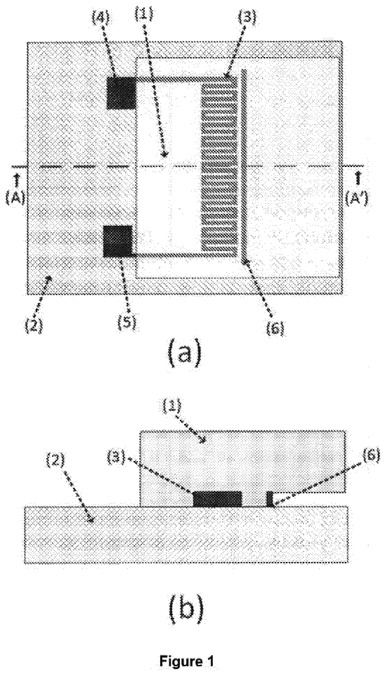

The object of the patent application is a manufacturing process for a plastic (1), that may be machined or not, to a substrate (2) with a metal resistor in the surface thereof (3) with the two electrical connections thereof (4), (5) and a barrier (6), such that the adhesion area is controlled. The process is based on the generation of heat produced by the Joule effect, when an electric current passes through an element that conducts electricity. An important characteristic of the invention is the inclusion of a mechanical-thermal barrier (6), the main function of which is to stop the temperature from increasing and lower it so that the plastic material solidifies exactly in the area where said barrier is present, and prevent the plastic from passing to the other side. In Figure 1, the process of the invention can be seen, wherein Figure 1(a) is a plan view of the plastic-substrate assembly before it is bonded; Figure 1(b) is the transversal cross section according to the plane A-A' of the final bonding of the plastic with the substrate. With this process, the plastic is kept from flowing past the mechanical-thermal barrier.

This invention, besides eliminating the use of bonding agents or tape, attempts to solve said technical difficulty by making an adhesion free from bonding agents possible, preventing the aforementioned problems of contamination and facilitating the manufacturing of said devices in a manner that is competitive, industrial and has a low cost.

The bonding can be performed with any plastic (1), machined or not, as long as it is in a solid state. The shape and size of the device can vary depending on the needs.

The conductor used for the invention can also be any metal; in the case of the embodiment present in Figure 1 (a and b), it is metal on a substrate (2). In the case of the example, it is a resistive metal element (3) with a serpentine shape, in order to achieve as much heating in the smallest area possible, such that a temperature level can be achieved which is greater than or equal to the glass transition temperature of the plastic (1), achieving the adhesion desired. In order to be able to introduce the current into the electrical circuit electrical connections (4) and (5) are used. The electrical current necessary to reach the desired temperature will depend on the shape and the arrangement of the conductor.

An important characteristic of the invention is the inclusion of a mechanical-thermal barrier (6), made with the same metal used for heating, but not electrically connected to it. The function of this mechanical-thermal barrier (6) is to limit the movement of the melted plastic and lower the temperature in the area thereof. The use thereof is due to the fact that when the heating of the plastic (1) is performed, it exceeds the glass transition point and flows. The mechanical-thermal barrier (6) delimits the flow of plastic towards the inside of the structure enabling it to maintain the desired shape. In particular, said shape is defined by the shape of the mechanical-thermal barrier (6).

Figure 1 (a and b) shows the device once the adhesion has been performed. To do so, first of all, the plastic (1) is placed on the substrate used (2). Once the plastic and the substrate have been aligned, a constant pressure is then exerted between them. This pressure serves to subsequently favour the adhesion of the system due to the fact that the plastic (1) which, when heated it will be above the glass transition state, will cover the resistive element (3) reaching the level of the substrate (2), and will favour the homogeneous transmission of heat.

### Embodiment of the invention

For the embodiment of the plastic portion, a sheet of poly (methyl methacylate) (PMMA) is used which is extruded and not machined (1). As a substrate, PCB (2) is used, made up of FR4 and copper Figure 1.

On the PCB, by means of a photolithographic process and copper etching the copper traces (3), (6) and the pads (4) and (5) are obtained. These copper traces (3), (6) and the pads (4) and (5) define: the resistor which acts as a heater (3), the mechanical-thermal barrier (6), the current input pad (4) and the ground connection pad (5).

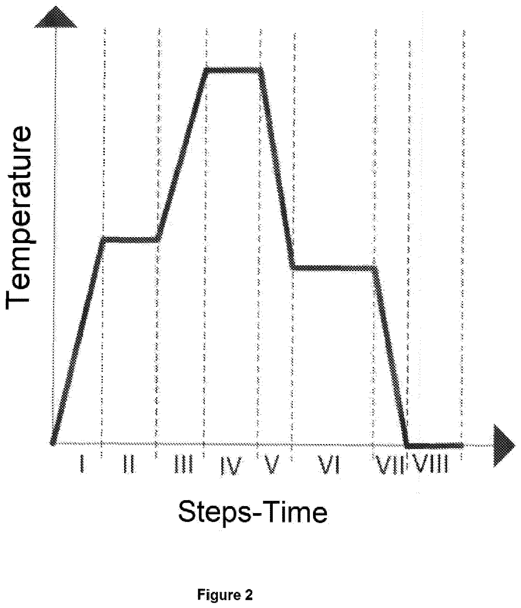

Once the RBG substrate has been manufactured, the bonding process is then started, Figure 2 (cross-section A-A') of Figure 1.

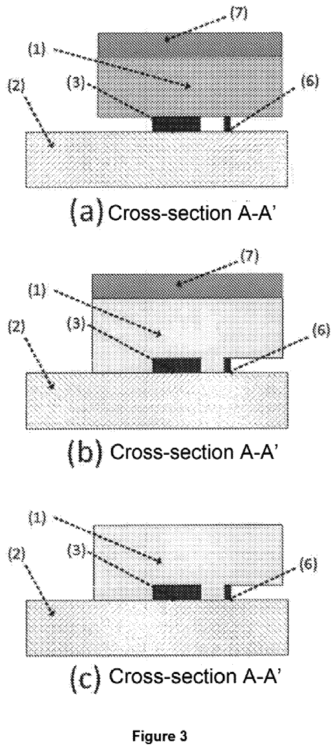

In order to perform the adhesion between the PMMA part (1) and the printed circuit board (2), (1) is placed on (2) such that the lower surface of the PMMA (1) is in contact with the upper face of the RGB (2). Furthermore, an element (7) is used to exert pressure on the assembly, Figure 3 (a), thereby improving the bonding. Subsequently, the difference in electric potential needed between the pads (4) and (5) is applied, which generates an intensity on the heater (3) which makes it start to increase the temperature thereof during a single heating step, transmitting that heat to the PMMA portion (1). The adhesion between the PMMA part (1) and the PCB substrate (2) starts to be produced when the glass transition temperature is exceeded in the base of the PMMA sheet (1), a temperature which is kept constant during a certain interval of time. The PCM (2) substrate contains a mechanical-thermal barrier consisting of a copper trace (6), situated next to the copper heater (3), making it so the temperature irradiated by said copper heater (3) is lesser as it nears said barrier (6), thereby preventing the melted PMMA from invading the area to the right of the barrier (6), Figure 3 (b).

Once a temperature greater than the glass transition has been reached, and once the melting of the base of the PMMA sheet (1) has been achieved, voltage ceases to be applied in a gradual manner, and in a single step, between the input pad (4) and the ground connection pad (5) and the pressure element (7) is maintained so that they continue to exert pressure between PMMA (1) and PCB (2) until it has completely cooled to room temperature. After this step, the pressure element (7) can be removed, the PMMA staying bonded to the PCB substrate with the adhesion area defined by the mechanical-thermal barrier (6), Figure 3 (c).

## Claims

1. A method for joining substrates and plastics using areas of controlled heat adhesion, **characterised in that**, starting from a substrate made up of two layers, one of them not being a conductor and the other being a resistive conductor, shape is given to the conductor layer by removing material by means of etching or other means such that two geometries are manufactured simultaneously, one of them with two electrical connections and another which operates as a mechanical-thermal barrier situating it next to the former, after which a plastic is placed on the resulting conductor layer, such that when an electrical current crosses through the geometry containing electrical connections, a temperature greater than or equal to the glass transition temperature of the plastic is generated which makes it adhere to the substrate, at the same time as it flows until stopping in the mechanical-thermal barrier whereon no current is circulating.

2. The method for joining substrates and plastics using areas of controlled heat adhesion according to the preceding claim, **characterised in that** the plastic is preferably poly (methyl metacrylate).

3. The method for joining substrates and plastics using areas of controlled heat adhesion according to claim 1, **characterised in that** the substrate is any material with deposition of a thermal conductor material on any of the surfaces thereof.

4. The method for joining substrates and plastics using areas of controlled heat adhesion, **characterised in that**, starting from a substrate, a resistive conductor layer is deposited and it is given a certain geometric shape which includes two electrical connections, after which a new resistive conductor layer is added made of another different conductor material and which is given a geometric shape which functions as a mechanical-thermal barrier, situating it next to the previous geometry, and a plastic is placed on the resulting conductor layers, such that when an electrical current crosses through the geometry containing the electrical connections, a temperature greater than or equal to the glass transition temperature of the plastic is generated which makes it adhere to the substrate at the same time as it flows until stopping in the mechanical-thermal barrier whereon no current is circulating.
